**Europäisches Patentamt**

**European Patent Office**

**Office européen des brevets**

(19)

(11) Veröffentlichungsnummer: **0 064 718**
**B1**

(12) # EUROPÄISCHE PATENTSCHRIFT

(45) Veröffentlichungstag der Patentschrift:
**11.03.87**

(21) Anmeldenummer: **82103781.9**

(22) Anmeldetag: **03.05.82**

(51) Int. Cl.⁴: **H 01 L 31/10, H 01 L 29/74**

(54) Lichtzündbarer Thyristor mit optoelektronisch angesteuerten Emitterkurzschlüssen und Verfahren zu seinem Betrieb.

(30) Priorität: **08.05.81 DE 3118364**

(43) Veröffentlichungstag der Anmeldung:
**17.11.82 Patentblatt 82/46**

(45) Bekanntmachung des Hinweises auf die Patenterteilung:
**11.03.87 Patentblatt 87/11**

(84) Benannte Vertragsstaaten:
**CH FR GB IT LI SE**

(56) Entgegenhaltungen:
**EP - A - 0 029 163**
**DE - A - 2 947 669**

(73) Patentinhaber: **Siemens Aktiengesellschaft Berlin und München, Wittelsbacherplatz 2, D-8000 München 2 (DE)**

(72) Erfinder: **Herberg, Helmut, Dr., Kobellstrasse 12, D-8000 München 2 (DE)**

ACTORUM AG

## Beschreibung

Die Erfindung bezieht sich auf einen lichtzündbaren Thyristor und auf Verfahren zu seinem Betrieb.

Beim Thyristor nach EP-A-0 029 163, Stand der Technik gemäss Art. 54 (3), weist der n-Emitter innerhalb eines lateralen lichtaktiven Halbleiterbereichs gategesteuerte MIS-Strukturen auf, die steuerbare Emitter-Kurzschlusspfade enthalten. Die MIS-Strukturen werden so angesteuert, dass die Emitter-Kurzschlusspfade im blockierenden Zustand des Thyristors bzw. vor seiner Zündung als Stabilisierungskurzschlüsse wirken. Als solche verhindern sie unbeabsichtigte Zündvorgänge, die z.B. beim Auftreten von höheren Blockierspannungen oder bei einem schnellen Anstieg solcher Blockierspannungen auftreten können. Während des Zündvorgangs sind dann die Emitter-Kurzschlusspfade abgeschaltet, um die Zündempfindlichkeit des Thyristors wesentlich zu erhöhen. Ein optoelektronischer Wandler, der mit einer den Thyristor zündenden Lichtquelle in optischem Kontakt steht und dessen Ausgang mit einem Steueranschluss der MIS-Strukturen verbunden ist, dient zur Ansteuerung der letzteren.

Der vorliegenden Erfindung liegt die Aufgabe zugrunde, einen Thyristor anzugeben, der eine einfache optoelektronische Ansteuerung für die Emitter-Kurzschlusspfade aufweist. Das wird erfindungsgemäss durch eine Ausbildung des Thyristors gemäss dem Patentanspruch 1 erreicht.

Der hiermit erzielbare Vorteil besteht insbesondere darin, dass der optische Kontakt zwischen einer die Zündleistung aufbringenden steuerbaren Lichtquelle und dem zur Ansteuerung der Emitter-Kurzschlusspfade dienenden optoelektronischen Wandler mit Hilfe von Schaltungsteilen hergestellt wird, die bereits für den optischen Kontakt zwischen der steuerbaren Lichtquelle und dem lichtaktiven Bereich des Thyristors zum Zwecke der Zündung vorgesehen sind.

Aus US-A-3 243 669, vgl. insbesondere Fig. 9, und DE-A-2 625 917 sind Thyristoren mit steuerbaren Emitter-Kurzschlusspfaden bekannt, die lediglich zum Zwecke eines schnellen Löschens der Thyristoren wirksam geschaltet werden. Aus DE-A-2 625 917 ist auch ein lichtzündbarer Thyristor bekannt, dessen steuerbare Emitter-Kurzschlusspfade während der Bestrahlung des Thyristors aus einer Zündlichtquelle wirksam geschaltet sind, um eine Zündung zu verhindern. Zu den hieraus bekannten steuerbaren Emitter-Kurzschlusspfaden gehören jeweils ein erstes Halbleitergebiet eines ersten Leitungstyps, das aus einem Randbereich des n(p)-Emitters besteht, ferner ein zweites Halbleitergebiet des ersten Leitungstyps, das im Abstand vom n(p)-Emitter in die an diesen angrenzende Basisschicht eingefügt ist, und ein zwischen diesen Halbleitergebieten liegender, einen zweiten Leitungstyp aufweisender Teilbereich der Basisschicht, der von einem isolierten Gate überdeckt ist. Steuerbare Emitter-Kurzschlusspfade, die vor dem Zünden des Thyristors als Stabilisierungskurzschlüsse dienen und insbesondere unabhängig vom Auftreten einer Blockierspannung wirksam geschaltet sind, während sie beim Zündvorgang unwirksam geschaltet sind, lassen sich hieraus jedoch nicht entnehmen.

Die Ansprüche 2 bis 8 betreffen Weiterbildungen des lichtzündbaren Thyristors nach der Erfindung, während der Anspruch 9 auf ein Verfahren zum Betrieb eines erfindungsgemässen Thyristors gerichtet ist.

Nachfolgend wird die Erfindung näher erläutert. Dabei zeigen:

Fig. 1 ein erstes Ausführungsbeispiel der Erfindung,

Fig. 2 eine alternative Ausgestaltung einer Teilschaltung von Fig. 1 und

Fig. 3 ein zweites Ausführungsbeispiel der Erfindung.

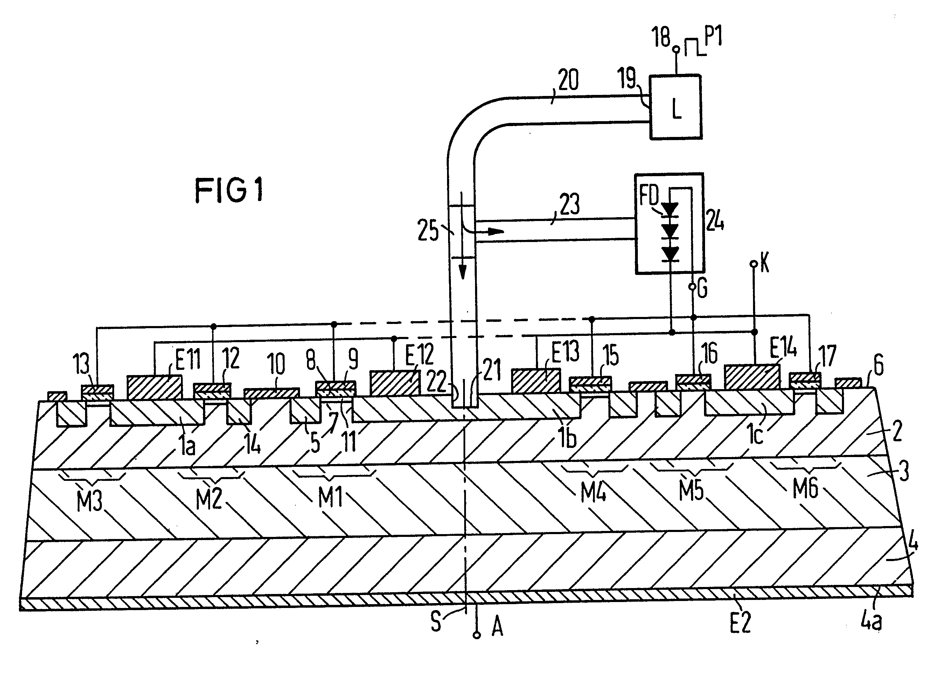

In Fig. 1 ist ein lichtzündbarer Thyristor mit einem Körper aus dotiertem Halbleitermaterial, z.B. Silizium, dargestellt, der vier aufeinanderfolgende Schichten abwechselnder Leitungstypen aufweist. Eine aus den Teilen 1a, 1b und 1c bestehende n-leitende Schicht bezeichnet man als den n-Emitter, eine p-leitende Schicht 2 als die p-Basisschicht, eine n-leitende Schicht 3 als die n-Basisschicht und eine p-leitende Schicht 4 als den p-Emitter. Die Teile 1a bis 1c des n-Emitters werden in der Grenzfläche 6 des Halbleiterkörpers von Teilen E11 bis E14 einer ersten Elektrode (Kathode) kontaktiert, die mit einem gemeinsamen Anschluss K verbunden sind. Die Teile E11 bis E14 bestehen aus einem elektrisch leitenden Material, z.B. Aluminium. Der p-Emitter 4 wird in der gegenüberliegenden Grenzfläche 4a des Halbleiterkörpers von einer zweiten Elektrode (Anode) E2 aus einem elektrisch leitenden Material, z.B. Aluminium kontaktiert, die mit einem Anschluss A verbunden ist.

Der Halbleiterkörper des Thyristors nach Fig. 1 weist die Form einer flachen, insbesondere runden Scheibe auf, während die Teile 1a bis 1c des n-Emitters jeweils streifenförmige, langgestreckte Halbleitergebiete darstellen können, die im wesentlichen senkrecht zur Bildebene von Fig. 1 über den gesamten Thyristorquerschnitt oder über Teile davon verlaufen.

Am linken Rand des n-Emitterteils 1b ist ein n-leitendes Kurzschlussgebiet 5 in die p-Basisschicht 2 eingefügt, das sich bis zur Grenzfläche 6 des Halbleiterkörpers erstreckt. Es weist einen Abstand von dem n-Emitterteil 1b auf, der durch die Breite eines Teilbereichs 7 der p-Basisschicht 2 bestimmt ist. Der Teilbereich 7 wird von einer auf der Grenzfläche 6 aufgebrachten, dünnen, elektrisch isolierenden Schicht 8 überdeckt, auf der ein Gate 9 aus elektrisch leitendem Material, z.B. aus hochdotiertem polykristallinen Silizium oder aus Metall, insbesondere Aluminium, aufgebracht ist. Das Gate 9 ist mit einem Steueranschluss G verbunden. Der linke Rand des Kurzschlussgebiets 5 wird von einer leitenden Belegung 10 kontaktiert, die den dort befindlichen pn-Übergang zwischen den Teilen 5 und 2 niederohmig überbrückt.

Die linke Randzone des n-Emitterteils 1b bildet hierbei ein erstes n-leitendes Halbleitergebiet einer MIS-Struktur M1, zu der weiterhin das Kurzschlussgebiet 5 als zweites n-leitendes Halbleitergebiet und der Teilbereich 7 als p-leitendes Halbleitergebiet sowie die Teile 8 und 9 gehören. Diese Struktur gehört dem Verarmungstyp an, so dass bei spannungslosem Gate 9 ein die Teile 1b und 5 niederohmig miteinander verbindender n-leitender Kanal 11 vorhanden ist. Der Kanal 11 kann z.B. aus einer Inversionsschicht bestehen, die durch ein an der Grenzfläche 6 oberhalb des Bereiches 7 herrschendes elektrisches Feld aufgebaut worden ist, oder kann ein sog. metallurgischer Kanal sein, der durch eine unmittelbar an der Grenzfläche 6 in den Bereich 7 eingefügte zusätzliche n-Dotierung gebildet ist. Die Teile 11 und 5 stellen in Verbindung mit der leitenden Belegung 10 einen Emitter-Kurzschlusspfad dar, der die Teile 1b und 2 niederohmig verbindet. Führt man dem Steueranschluss G eine negative Spannung zu, so wird der Kanal 11 aufgehoben bzw. hochohmig geschaltet, wobei auch der genannte Emitter-Kurzschlusspfad abgeschaltet ist.

Eine zweite, entsprechend aufgebaute MIS-Struktur M2 ist am rechten Rand des n-Emitterteils 1a vorgesehen, sowie eine dritte, entsprechend aufgebaute MIS-Struktur M3 am linken Rand von 1a. Die Gates 12 und 13 von M2 und M3 sind ebenfalls an den Steueranschluss G geführt. Die leitende Belegung 10 ist in Fig. 1 soweit nach links verlängert, dass sie auch das Kurzschlussgebiet 14 von M2 kontaktiert und somit den pn-Übergang zwischen den Teilen 14 und 2 am rechten Rand von 14 niederohmig überbrückt.

Der Thyristor nach Fig. 1 ist nach einer ersten Ausgestaltung symmetrisch zu einer Symmetrieebene aufgebaut, die auf die Bildebene von Fig. 1 senkrecht steht und durch eine strichpunktierte Linie S angedeutet ist. Den Strukturen M1 bis M3 entsprechen dann weitere Strukturen M4 bis M6 in der rechten Hälfte von Fig. 1. Die Gates 15 bis 17 dieser Strukturen sind auch mit dem Steueranschluss G verbunden.

Eine steuerbare Lichtquelle L, insbesondere eine Lumineszenzdiode, Laserdiode oder dgl., weist einen Steuereingang 18 und einen optischen Ausgang 19 auf, der mit dem Eingang eines Lichtleiters 20 gekoppelt ist. Das Ende 21 des Lichtleiters ragt in eine Ausnehmung 22 des n-Emitterteils 1b. Abweichend hiervon kann das Ende 21 des Lichtleiters 20 auch auf einen sich bis zur Grenzfläche 6 erstreckenden Teilbereich der p-Basisschicht 2 gerichtet sein oder soweit in den Halbleiterkörper eingeführt sein, dass es in die p-Basisschicht 2 hineinragt. Von dem Lichtleiter 20 zweigt ein Lichtleiter 23 ab, der an den optischen Eingang eines optoelektronischen Wandlers 24 gekoppelt ist. Dieser enthält eine Serienschaltung von mehreren Halbleiter-Fotodioden FD, insbesondere PIN-Dioden, die zwischen den Anschluss K der Elektrode E11 bis E14 und den Steueranschluss G geschaltet ist. Die Fotodioden sind dabei so gepolt, dass die bei einer Bestrahlung durch den Lichtleiter 23 eine Fotospannung an G auftritt, die G auf ein negatives Potential gegenüber K legt. Ein Teil der von L ausgehenden, im Lichtleiter 20 geführten Strahlung wird mittels eines Strahlteilers 25 der in den Lichtleiter 20 eingefügt ist, in den Lichtleiter 23 überkoppelt und beaufschlagt die Fotodioden FD.

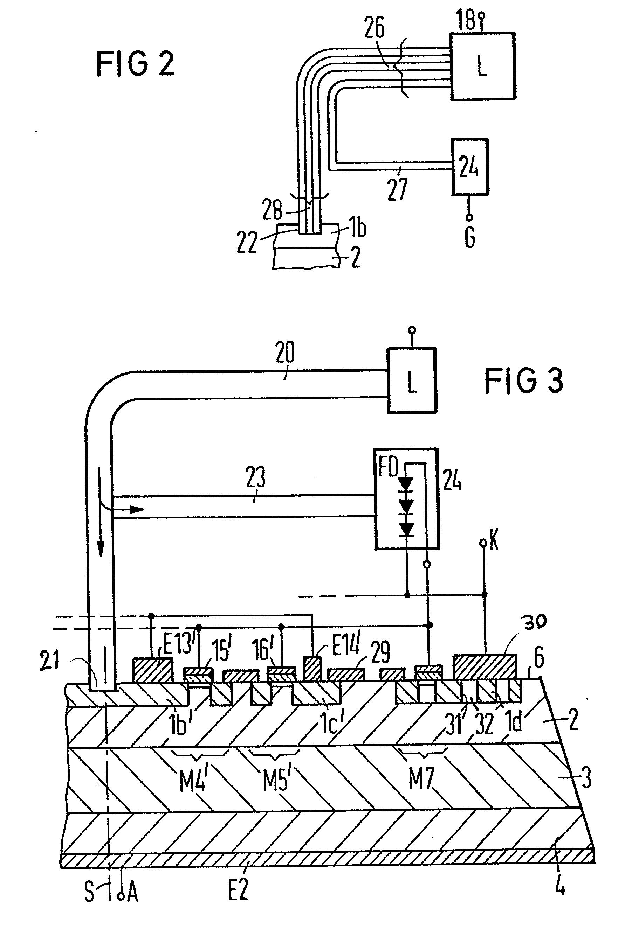

Gemäss Fig. 2 kann die optische Ansteuerung des Wandlers 24 auch so gelöst sein, dass aus einem mit dem Ausgang 29 der Lichtquelle L verbundenen Lichtfaserbündels 26 ein Teil 27 dieser Lichtfasern abgebogen ist und zu dem optoelektronischen Wandler 24 hin verläuft, während ein anderer, insbesondere grösserer Teil 28 der Lichtfasern mit dem Halbleiterkörper des Thyristors in optischem Kontakt steht.

Im Betrieb liegt ein äusserer Laststromkreis an den Anschlüssen A und K, der die Serienschaltung einer Spannungsquelle und eines Lastwiderstandes enthält. Legt diese Spannungsquelle den Anschluss A auf ein positiveres Potential als K, so befindet sich der Thyristor nach Fig. 1 zunächst im blockierenden Zustand, in dem kein nennenswerter Laststrom zwischen A und K fliesst. Die in der Basisschicht 2 thermisch generierten Defektelektroden werden über die bei spannungslosem Steueranschluss G wirksam geschalteten Emitter-Kurzschlusspfade, z.B. 11, 5, 10 der Strukturen M1 bis M6 zu den Teilen E11 bis E14 der Kathode abgeleitet, so dass aus den n-Emitterteilen 1a bis 1c keine Ladungsträgerinjektion in die Basisschicht 2 erfolgt, die zur Zündung führen würde.

Um den Thyristor zu zünden, wird dem Steuereingang 18 ein Stromimpuls P1 zugeführt, der L zur Abgabe eines Lichtimpulses veranlasst. Hierdurch werden unterhalb des Endes 21 des Lichtleiters 20 durch die Lichteinwirkung in der Basisschicht 2 Ladungsträger erzeugt, die zusammen mit thermisch generierten Ladungsträgern unter dem Einfluss der Spannung zwischen A und K in Richtung auf den n-Emitterteil 1b transportiert werden. Die durch einen Teil des Lichtimpulses bestrahlten Fotodioden FD liefern eine an G abgreifbare, negative Fotospannung, durch die n-Kanäle, z.B. 11, und somit die auch die Emitter-Kurzschlusspfade, z.B. 11, 5, 10, unterbrochen werden. Bei einer Serienschaltung von acht Fotodioden FD entsteht z.B. eine Fotospannung von 4V und ein Fotostrom von etwa $10^{-3}$ bis $10^{-4}$A, was für eine Ansteuerung der Gates von M1 bis M6 ausreicht. Eine Verwendung von PIN-Fotodioden ergibt Anstiegszeiten der Fotospannung, die bei etwa 1 μs liegen. Durch einen Betrieb der Fotodioden ohne sperrende Vorspannung entsteht eine Verzögerung beim Abbau der Fotospannung nach Beendigung des Lichtimpulses. Da die Emitter-Kurzschlusspfade unwirksam geschaltet sind, gelangen die in Richtung auf den n-Emitter 1b transportierten Ladungsträger zum pn-Übergang zwischen 1b und 2 und bewirken eine Injektion von Ladungsträgern in die p-Basisschicht 2. Damit zündet der Thyristor auch bei kleinen Lichtleistungen der Lichtquelle L. Von 1b ausgehend breitet sich der gezündete Teil des Thyristors wegen der unwirksam geschalteten Emitter-Kurzschlusspfade sehr rasch auch auf die äusseren Bereiche des Thyristorquerschnitts aus, in denen die n-Emitterteile 1a und 1c angeordnet sind, so dass der Laststrom des angeschlossenen Laststromkreises sehr schnell von dem gesamten Thyristorquerschnitt aufgenommen wird. Die Abschaltung des Thyristors erfolgt dann, wenn der Laststrom einen Haltewert unterschreitet, was beispielsweise durch eine Unterbrechung des Laststromkreises erfolgt oder, wenn es sich bei der Spannungsquelle im Laststromkreis um eine Wechselspannungsquelle handelt, durch den nachfolgenden Nulldurchgang der Wechselspannung.

In Fig. 3 ist ein anderes Ausführungsbeispiel der Erfindung dargestellt, das n-Emitterteile 1b' und 1c' aufweist, die mit Teilen E13' und E14' einer ersten Elektrode belegt sind. Randseitig zu den Teilen 1b' und 1c' sind MIS-Strukturen M4' und M5' vorgesehen, deren Gates mit 15' und 16' bezeichnet sind. Diese Schaltungsteile entsprechen weitgehend den Teilen 1b, 1c, E13, E14, M4, M5, 15 und 16 von Fig. 1. Zum Unterschied von diesen sind die Teile E13' und E14' zwar untereinander, jedoch nicht mit dem Anschluss K verbunden. Ausserdem tritt an die Stelle der MIS-Struktur M6 von Fig. 1 eine leitende Belegung 29, die in Fig. 3 den pn-Übergang am rechten Rand des n-Emitterteils 1c' niederohmig überbrückt. Infolge dieser Abänderungen stellen die n-Emitterteile 1b' und 1c' einen sog. Hilfsemitter dar, während die Elektrodenteile E13' und E14' zusammen mit der leitenden Belegung 29 eine Hilfsmittelelektrode (amplifying gate) bilden. Weiterhin ist in Fig. 3 ein n-Emitterteil 1d vorgesehen, der den Hauptemitter des Thyristors bildet. Dieser ist mit einer Kathode 30 aus elektrisch leitendem Material, z.B. aus hochdotiertem polykristallinen Silizium oder aus Metall, z.B. Aluminium, versehen, die mit dem Anschluss K verbunden ist. Die übrigen Schaltungsteile von Fig. 3 entsprechen den gleichbezeichneten Teilen von Fig. 1 nach Aufbau und Wirkungsweise. Der n-Emitterteil 1d ist an seinem linken Rand mit einer MIS-Struktur M7 versehen, die nach Aufbau und Wirkungsweise beispielsweise der Struktur M1 von Fig. 1 entspricht. Zweckmässigerweise ist der n-Emitterteil 1d noch mit Ausnehmungen 31 versehen, die von Ansätzen 32 der p-Basisschicht 2 durchdrungen werden, welche in der Grenzfläche 6 von der Kathode 30 kontaktiert werden. Die Teile 31, 32 stellen sog. feste Emitterkurzschlüsse dar, die die Stabilität im Bereich des Hauptemitters 1d erhöhen.

Im blockierenden Zustand des Thyristors nach Fig. 3 sind die Emitter-Kurzschlusspfade in den Strukturen M4', M5' und M7 wirksam geschaltet, was wegen der Ausbildung dieser Strukturen als solche des Verarmungstyps entsprechend Fig. 1 bei spannungslosem Steueranschluss G der Fall ist. Zum Zünden des Thyristors führt man dem Anschluss 18 einen Stromimpuls P1 zu. Hierdurch wird wieder einerseits der lichtaktive Bereich unterhalb des Endes 21 des Lichtleiters 20 aus der steuerbaren Lichtquelle L angestrahlt, während gleichzeitig die Emitter-Kurzschlusspfade in den Strukturen M4', M5' und M7 aufgehoben bzw. abgeschaltet werden. Damit zündet der Thyristor bei kleinen Lichtleistungen der Lichtquelle L zunächst im Bereich des Hilfsemitters 1b' und 1c'. Der über den Hilfsemitter fliessende Strom wird über die leitende Belegung 29 in Richtung auf den Hauptemitter 1d umgelenkt und stellt einen grossen Zündstrom für diesen Thyristorteil dar, der zu einer schnellen und grossflächigen Zündung des Thyristorquerschnitts im Bereich des Hauptemitters 1d führt. Anschliessend wird der Thyristor im Bereich des Hilfsemitters 1b', 1c' wieder gelöscht, wobei der gesamte Laststrom durch den Teil des Thyristorquerschnitts aufgenommen wird, der den Hauptemitter 1d enthält. Nach dem Abbau der Fotospannung an G sind die Emitter-Kurzschlusspfade der Strukturen M4', M5' und M7 wieder wirksam geschaltet, ohne dass der im Bereich des Hauptemitters 1d stattfindende Stromdurchgang hiervon beeinflusst wird.

Gemäss einer weiteren Ausgestaltung der Erfindung sind die Thyristoren nach den Figuren 1 und 3 in Abweichung von der bisherigen Beschreibung rotationssymmetrisch ausgebildet. Die strichpunktierte Linie S kann hierbei als Symmetrieachse aufgefasst werden. Die dargestellten Teilstrukturen sind dann kreisringförmig ausgebildet, wobei die gestrichelt dargestellten horizontalen Verbindungsleitungen in den Figuren 1 und 3 entfallen.

Im Rahmen der Erfindung kann auch der p-Emitter 4 anstelle des n-Emitters mit MIS-Strukturen versehen sein, die steuerbare Emitter-Kurzschlusspfade enthalten. Die Figuren 1 und 4 können zur Darstellung dieser Variante herangezogen werden, wenn die Bezeichnungen der Anschlüsse A und K miteinander vertauscht werden, die dargestellten Halbleitergebiete die jeweils entgegengesetzten Leitungstypen aufweisen und die dem Anschluss G zugeführten Spannungen bzw. Spannungsimpulse jeweils umgepolt werden.

Die Eindringtiefe der n-Emittergebiete 1a, 1b und 1c sowie der Kurzschlussgebiete, z.B. 5 und 14, in die p-Basisschicht 2 kann beispielsweise 3 µm betragen. Hierbei kommen dann für die Abstände der Kurzschlussgebiete 5 und 14 von den zugeordneten n-Emittergebieten 1b und 1a z.B. jeweils 5 µm in Betracht. Die lateralen Abmessungen der Kurzschlussgebiete 5, 14 usw. in der Bildebene von Fig. 1 können z.B. jeweils 10 µm betragen. Die Dicke des Halbleiterkörpers des Thyristors nach den Figuren 1 oder 3 liegt z.B. in einem Bereich von 200 µm bis 1 mm.

**Patentansprüche**

1. Lichtzündbarer Thyristor mit einem Halbleiterkörper, der einen von einer ersten Elektrode kontaktierten n-Emitter (1a, 1b, 1c) mit einer angrenzenden p-Basisschicht (2) und einen von einer zweiten Elektrode kontaktierten p-Emitter (4) mit einer angrenzenden n-Basisschicht (3) aufweist, und mit an einer Grenzfläche des Halbleiterkörpers angeordneten, als gategesteuerte MIS-Strukturen (M1–M6) ausgebildeten, steuerbaren Emitterkurzschlüssen, jeweils bestehend aus einem mit der ersten bzw. zweiten Elektrode verbundenen ersten Halbleitergebiet (1b) eines ersten Leitungstyps, einem mit einer Basisschicht (2) verbundenen zweiten Halbleitergebiet (5) des ersten Leitungstyps und einem zwischen diesen Halbleitergebieten liegenden Halbleiterbereich (7) eines zweiten Leitungstyps, der von einem gegenüber dem Halbleiterkörper elektrisch isolierten Gate (9) überdeckt ist, wobei eine steuerbare Lichtquelle (L) vorgesehen ist, die über einen Lichtleiter (20) mit einem Teil der Oberfläche des Halbleiterkörpers in optischem Kontakt steht, wobei die gategesteuerten MIS-Strukturen einen gemeinsamen Steueranschluss (G) haben, der mit dem Ausgang eines optoelektronischen Wandlers (24) verbunden ist, welcher mit der gesteuerten Lichtquelle in optischem Kontakt steht, und wobei ein von dem Lichtleiter (20) abzweigender Lichtleiter (23) vorgesehen ist, der mit einem Eingang des optoelektronischen Wandlers (24) verbunden ist.

2. Lichtzündbarer Thyristor nach Anspruch 1, dadurch gekennzeichnet, dass der optoelektronische Wandler (24) eine Serienschaltung von mehreren Halbleiter-Fotodioden (FD) aufweist.

3. Lichtzündbarer Thyristor nach Anspruch 2, dadurch gekennzeichnet, dass die Anschlüsse der Serienschaltung der Halbleiter-Fotodioden mit dem gemeinsamen Steueranschluss (G) der MIS-Strukturen und mit einem Anschluss der ersten Elektrode beschaltet sind.

4. Lichtzündbarer Thyristor nach einem der Ansprüche 1 bis 3, dadurch gekennzeichnet, dass die Halbleiter-Fotodioden aus PIN-Dioden bestehen.

5. Lichtzündbarer Thyristor nach einem der Ansprüche 1 bis 4, dadurch gekennzeichnet, dass der optische Ausgang der steuerbaren Lichtquelle (L) mit einem Lichtfaserbündel (26) in Verbindung steht, von dem jeweils eine erste Gruppe von Lichtfasern (28) mit einem Teil der Oberfläche des Halbleiterkörpers und eine zweite Gruppe von Lichtfasern (27) mit dem Eingang des optoelektronischen Wandlers (24) in optischem Kontakt steht.

6. Lichtzündbarer Thyristor nach einem der Ansprüche 1 bis 5, dadurch gekennzeichnet, dass der n(p)-Emitter in eine Mehrzahl von streifenförmigen Emitterteilen (1a bis 1c) aufgeteilt ist, die mit untereinander verbundenen Teilen (E11 bis E14) der ersten (zweiten) Elektrode versehen sind und dass eine Mehrzahl von streifenförmig ausgebildeten MIS-Strukturen randseitig zu den streifenförmigen Emitterteilen angeordnet sind.

7. Lichtzündbarer Thyristor nach einem der vorhergehenden Ansprüche, dadurch gekennzeichnet, dass die erste bzw. zweite Elektrode aus einer Kathode bzw. Anode besteht.

8. Lichtzündbarer Thyristor nach einem der Ansprüche 1 bis 6, dadurch gekennzeichnet, dass die erste bzw. zweite Elektrode (E13′, E14′) aus einer Hilfsemitterelektrode besteht.

9. Verfahren zum Betrieb eines lichtzündbaren Thyristors, nach einem der vorhergehenden Ansprüche, dadurch gekennzeichnet, dass den gategesteuerten MIS-Strukturen ein am Ausgang des optoelektronischen Wandlers (24) abgreifbarer, die Emitter-Kurzschlüsse für die Dauer des Zündvorgangs unwirksam schaltender Spannungsimpuls zugeführt wird.

## Claims

1. A light-ignitable thyristor comprising a semiconductor body which has an n-emitter (1a, 1b, 1c) contacted by a first electrode, with an adjacent p-base layer (2), and a p-emitter (4) contacted by a second electrode, with an adjacent n-base layer (3), and controllable emitter short circuits arranged at a boundary surface of the semiconductor body, in the form of gate-controlled MIS-structures (M1–M6), each consisting of a first semiconductor zone (1b) of a first conductivity type which is connected to the first or second electrode, a second semiconductor zone (5) of the first conductivity type which is connected to the base layer (2), and a semiconductor zone (7) of a second conductivity type which is located between these semiconductor zones and which is covered by a gate (9) which is electrically insulated from the semiconductor body, where a controllable light source (L) is provided which is in optical contact, through a light conductor (20), with a part of the surface of the semiconductor body, where the gate controlled MIS-structures have a common control terminal (G) which is connected to the output of an opto-electronic transducer (24) which is in optical contact with the controlled light source, and where a light conductor (23) is provided which branches off from the light conductor (20) and is connected to an input of the opto-electronic transducer (24).

2. A light-ignitable thyristor as claimed in Claim 1, characterised in that the opto-electronic transducer (24) comprises a series arrangement of a plurality of semiconductor photo-diodes (FD).

3. A light-ignitable thyristor as claimed in Claim 2, characterised in that the terminals of the series arrangement of the semiconductor photo-diodes are connected to the common control terminal (G) of the MIS-structures and to a terminal of the first electrode.

4. A light-ignitable thyristor as claimed in one of Claims 1 to 3, characterised in that the semiconductor photo-diodes consist of PIN-diodes.

5. A light-ignitable thyristor as claimed in one of Claims 1 to 4, characterised in that optical output of the controllable light source (L) is connected to an optical fibre bundle (26), of which a first group of optical fibres (28) is in optical contact with part of the surface of the semiconductor body and a second group of optical fibres (27) is in optical contact with the input of the opto-electronic transducer (24).

6. A light-ignitable thyristor as claimed in one of Claims 1 to 5, characterised in that the n(p)-emitter is divided into a plurality of strip-shaped emitter parts (1a to 1c) which are provided with parts (E11 to E14) of the first (second) electrode connected to one another; and that a plurality of strip-shaped MIS-structures are arranged edge-wise to the strip-shaped emitter parts.

7. A light-ignitable thyristor as claimed in one of the preceding Claims, characterised in that the first and second electrodes consist of a cathode and an anode respectively.

8. A light-ignitable thyristor as claimed in one of the Claims 1 to 6, characterised in that the first or second electrode (E13', E14'), as the case may be, consists of an auxiliary emitter electrode.

9. A method of operating a light-ignitable thyristor as claimed in one of the preceding Claims, characterised in that the gate-controlled MIS-structures are supplied with a voltage pulse which can be tapped from the output of the opto-electronic transducer (24) and which renders inactive the emitter short circuits for the duration of the ignition process.

## Revendications

1. Thyristor pouvant être amorcé par la lumière, comprenant un corps semi-conducteur qui présente un émetteur n (1a, 1b, 1c) mis en contact avec une première électrode et voisin d'une couche de base p (2), un émetteur p (4) mis en contact avec une seconde électrode et voisin d'une couche de base n (3), ainsi que des courts-circuits d'émetteur commandés, disposés à une surface limite du corps semi-conducteur et formés par des structures MIS (M1–M6) commandées par la grille, qui sont constitués chacun d'une première région de semi-conducteur (1b), d'un premier type de conductivité, reliée à la première respectivement la seconde électrode, d'une deuxième région de semi-conducteur (5), du premier type de conductivité, reliée à une couche de base (2), et d'une zone de semi-conducteur (7), d'un second type de conductivité, située entre ces régions et recouverte par une grille (9) électriquement isolée par rapport au corps semi-conducteur, avec prévision d'une source lumineuse (L) commandée et en contact optique avec une partie de la surface du corps semi-conducteur à travers un conducteur de lumière (20), les structures MIS ayant une borne de commande (G) commune, connectée à la sortie d'un convertisseur optoélectronique (24) qui est en contact optique avec la source lumineuse commandée, et avec prévision d'un conducteur de lumière (23) qui bifurque dudit conducteur de lumière (20) et est relié à une entrée du convertisseur optoélectronique (24).

2. Thyristor selon la revendication 1, caractérisé en ce que le convertisseur optoélectronique (24) présente un montage en série de plusieurs photodiodes à semi-conducteur (FD).

3. Thyristor selon la revendication 2, caractérisé en ce que les bornes du montage en série des photodiodes sont connectées à la borne de commande (G) commune des structures MIS et à une borne de la première électrode.

4. Thyristor selon une des revendications 1 à 3, caractérisé en ce que les photodiodes sont des diodes PIN.

5. Thyristor selon une des revendications 1 à 4, caractérisé en ce que la sortie optique de la source lumineuse (L) est en liaison avec un faisceau de fibres optiques (26) dont un premier groupe de fibres (28) est en contact optique avec une partie de la surface du corps semi-conducteur et dont un deuxième groupe de fibres (27) est en contact optique avec l'entrée du convertisseur optoélectronique (24).

6. Thyristor selon une des revendications 1 à 5, caractérisé en ce que l'émetteur n(p) est partagé en parties d'émetteur ayant la forme de bandes (1a à 1c), qui sont pourvues de parties (E11 à E14) reliées entre elles de la première (seconde) électrode, et que des structures MIS en forme de bandes sont disposées aux bords des parties d'émetteur en forme de bandes.

7. Thyristor selon une des revendications précédentes, caractérisé en ce que la première respectivement la seconde électrode constitue une cathode respectivement une anode.

8. Thyristor selon une des revendications 1 à 6, caractérisé en ce que la première respectivement la seconde électrode (E13', E14') est une électrode d'émetteur auxiliaire.

9. Procédé pour le fonctionnement d'un thyristor selon une des revendications précédentes, caractérisé en ce que l'on applique, aux structures MIS commandées par la grille, une impulsion de tension pouvant être prélevée à la sortie du convertisseur optoélectronique (24) et rendant les courts-circuits d'émetteur inopérants pendant la durée du processus d'amorçage.

# FIG 1

0 064 718

# FIG 2

# FIG 3